# EUROPEAN PATENT SPECIFICATION

(11) **EP 2 843 721 B1**
(45) Date of publication and mention of the grant of the patent: **04.11.2015**
(21) Application number: 13306201.8
(22) Date of filing: 03.09.2013
(51) Int. Cl.: H01L 39/16, H01F 6/06

(54) **Superconductor coil arrangement**
Spulenanordnung für Supraleiter
Agencement de bobines supraconductrices

(43) Date of publication of application: 04.03.2015
(73) Proprietor: Nexans, 75008 Paris (FR)
(72) Inventor: Hobl, Achim, 51503 Rösrath (DE)
(74) Representative: Feray, Valérie

(56) References cited:
- US-A1- 2008 070 788
- US-A1- 2009 286 685

## Description

The present invention relates to a coil arrangement of at least one stripe-shaped superconductor assembly wherein the stripe-shaped superconductor assembly can be a superconductor stripe with metal substrate and superconductor layer formed onto at least one side of the metal substrate.

The superconductor stripe can be a tape or wire. According to need one or more buffer layer(s) can be provided between the substrate and the superconductor layer as well as onto the superconductor layer.

The metal substrate can be biaxially textured, for example, by deformation process.

The superconductor material can be a high temperature superconductor (hts) material including rare earth oxide, for example REBa₂Cu₃O₇-δ wherein RE is selected from the group consisting of rare earth elements and Yttrium, and δ is a number of greater than 0 and less than 1.

It is well known to wind superconductor tapes or wires into a coil configuration for obtaining a compact space saving design wherein a maximum length of superconductor tape or wire requires as little volume as possible.

A particular application of such compact coil arrangement of superconductor stripes such as tapes or wires is in resistive fault current limiters.

Superconducting fault current limiters make use of the unique transition characteristics of superconducting material. When a fault occurs in a power transmission system connected with a resistive superconductor fault current limiter, the current density in the superconductor material exceeds the critical current density of the material, and the superconductor material undergoes transition from its superconducting state into its normal resistive state thereby limiting the current flow.

Preferably in the coil arrangement the current path is designed such that in adjacent turns of the coil current flow is in opposite direction in order to minimize induction.

Such a coil arrangement wherein the current path is designed such that current flow in adjacent turns is in opposite direction is also referred to "coil arrangement of low inductance".

In the well-known bifilar superconductor coil arrangement the superconductor tape or wire changes direction at one end of the coil, also referred to reversal point, and is returned in parallel to the first winding to the opposite end of the coil, i.e. the starting point of the coil winding. Due to the bifilar winding current flow and, as a consequence, the orientation of the magnetic field induced by the current flow is in opposite direction in adjacent turns. Since the magnetic fields are in opposite direction the "sum" of the magnetic fields is about zero and induction in the coil arrangement is minimized.

There are known helical bifilar coils and flat spiral bifilar coils, so called pancake coils. A typical example of a bifilar pancake coil is disclosed in US2008/0070788 A1 or in EP 1 797 599 B1.

A typical problem in bifilar coil winding, irrespectively whether helical or pancake arrangement, is that the starting and end points of the winding, i.e. current input and output, are very close to each other, so that all of the voltage applied across the coil appears between these two points and makes provision of good electrical insulation necessary for avoiding short-circuit.

US 2011/0116198 A1 relates to a flat spiral bifilar coil arrangement with improved distance between current input and current output. For obtaining increased distance two or more superconductor tapes or wires are arranged on a common plane and are shaped to form a common coil winding, wherein each of the superconductor tapes or wires form a bifilar structure with the reversal point of each bifilar structure being located around the center of the spiral. In the result a larger distance between the starting and end point of each bifilar structure of the coil assembly can be obtained

US 6,275,365 B1 relates to a fault current limiter composed of a plurality of bifilar pancake coils. Each pancake coil is separated by an insulation layer and is wound from the same continuous length of superconducting tape. The individual coils are stacked on top of each other along a longitudinal axis for obtaining a relatively compact superconducting fault current limiter with minimized total inductance.

Another approach for obtaining a coil arrangement with minimized inductance is disclosed in EP 2 472 532 A1. According to this approach a hts tape or wire is wound onto two adjacent longitudinal axes in a manner that adjacent turns of the first axis show current flow in opposing directions wherein at least two turns on the first axis are connected in series via at least one turn on the second axis. The resulting coil arrangement is monofilar rather than bifilar thereby avoiding change of direction at one end of the coil (i.e. the reversal point) and, further, the maximum voltage drop between adjacent turns is only a fraction of the voltage drop across the entire coil.

In the known bifilar coil winding of superconductor stripes the substrate side is oriented in the same direction and points either inwards or outwards of the coil. In such arrangement the substrate side of a first turn faces the superconductor layer side of the adjacent turn with opposite current flow.

As set out above conventional bifilar coils with substrate orientation towards the same direction are advantageous in that the inductance is only low since the overall sum of the magnetic fields is zero.

However, this situation is completely different when considering local parts of such conventional bifilar coil. In local parts significant local magnetic fields exist between adjacent turns with opposite current flow so that the substrate of a first turn which faces the superconductor layer of the adjacent turn, is in a region of magnetic field. Such an exposition of metal substrates to magnetic field is disadvantageous in particular in AC applications due to the changing magnetic field. Interaction of the magnetic field with the metal of the substrate leads to considerable AC losses due to both hysteretic and eddy current effects. These AC losses are particularly significant in cases where the metal is ferromagnetic. For example, Nickel and its alloys which are commonly used as metal substrate for superconductor stripes such as known as coated conductors, are typical ferromagnetic materials.

These power losses cause high cryogenic requirements and consequently increased costs.

AC losses due to hysteretic and eddy current effects are a problem in any superconductor coil arrangement wherein the superconductor material, irrespectively whether low or high temperature superconductor, is adjacent to a normally conductive metal, in particular ferromagnetic metal.

It was the object of the present invention to provide a coil arrangement of low inductance, such as for example a bifilar coil arrangement, for superconductor stripes comprising a metal substrate and deposited thereon a superconductor layer, having reduced AC losses along the coil.

This object is solved by a coil arrangement of at least one stripe-shaped superconductor assembly with metal substrate and superconductor layer formed onto at least one side of the metal substrate wherein the at least one stripe-shaped superconductor assembly is formed into a coil arrangement wherein in adjacent turns current flow is an opposite direction in operation, and wherein in the stripe-shaped superconductor assembly the metal substrate is sandwiched between superconductor layers with same current flow direction in operation.

According to the coil arrangement of the present invention the substrate side of the stripe-shaped superconductor assembly is sandwiched between two superconductor layers.

In this arrangement the current path of the coil is formed by a sandwich structure with the metal substrate side being sandwiched between two superconductor layers.

Further, in adjacent turns of the coil arrangement with opposite direction of current flow the superconductor layer side of a first turn faces the superconductor layer side of the adjacent turns, i.e. the turn following the first turn and the turn preceding the first turn.

Due to this sandwich architecture the substrate side of each turn is positioned in a region without magnetic field, and only in the region between the superconductor layer side of adjacent turns of the coil winding a magnetic field is generated.

In principle the coil arrangement of the present invention is suitable for any coil winding wherein in adjacent turns current flows in opposite direction.

The coil arrangement can be a conventional bifilar coil winding with the stripe-shaped superconductor assembly being wound into a first coil part and is returned in parallel to the first coil part forming the second coil part.

Two or more stripe-shaped superconductor assemblies can be wound into coil configuration side by side and being returned. In this case, the two or more stripe-shaped superconductor assemblies or some of them can run together in a common reversal point and being returned from said common reversal point.

The present coil arrangement is suitable for any superconductor stripe comprising a stripe-shaped metal substrate wherein at least one side of the metal substrate is coated with a superconductor layer.

According to one embodiment of the present invention the stripe-shaped superconductor assembly can be composed of two superconductor stripes, each superconductor stripe comprising a metal substrate and a superconductor layer formed thereon. The two superconductor stripes are arranged in parallel with the substrate sides facing each other and the superconductor layer sides pointing outwards.

When such stripe-shaped superconductor assembly is formed into a coil winding of low inductance with current flow in opposite direction in adjacent turns, the superconductor layer side of a given turn faces the superconductor layer side of the adjacent turns with current flow in opposite direction and the metal substrate side being in a position of no magnetic field.

According to another embodiment of the present invention the stripe-shaped superconductor assembly can be composed of a superconductor stripe wherein on both, the top and bottom side, of the metal substrate a superconductor layer is formed.

According to need one or more buffer layers can be provided between substrate and the superconductor layer and/or onto the superconductor layer. Such superconductor stripes, materials therefore and fabrication methods are known per se.

The superconductor material can be anyone of low and high temperature superconductor materials and MgB₂. High temperature superconductor materials are those having a critical temperature above the temperature of liquid nitrogen (77 K.). HTS materials are preferred for example in view of the use of liquid nitrogen as cooling medium which is comparatively cheaper than, e.g., liquid helium.

Examples of suitable hts materials are rare earth oxides, for example REBa₂ Cu₃O_{7-δ}, wherein RE is at least one from the group consisting of rare earth elements and Yttrium, and δ is a number of greater 0 and less than 1, Bismuth-Strontium-Calcium-Copper-Oxide superconductors (BSCCO) and Thallium based superconductors.

Typical buffer layers are metal oxides such as CeO₂, YSZ (Yttria stabilized Zirconia), Y₂O₃ and SrTiO₃ as well as metals such as Silver, Nickel etc. Preferably a layer of non-ferromagnetic metal is provided onto the superconductor layer, e.g. silver, gold, copper.

The metal material for the substrate can include metal and metal alloys such as Nickel, Nickel-Tungsten, Nickel-Chromium, Nickel-Copper, Nickel-Vanadium or Hastelloy, Stainless steel or any other suitable normally conductive metal or metal alloy.

For the fabrication of the coil arrangement of the present invention the stripe-shaped superconductor assembly can be composed of two superconductor stripes wherein a superconductor layer is provided on one side of the metal substrate.

In this case the current path is formed by two superconductor stripes wound in parallel into the coil arrangement of the present invention, wherein the substrate side of each superconductor stripe faces each other.

The superconductor layer side of each superconductor stripe points towards the adjacent turns with current flow in opposite direction in operation.

Considering the overall coil arrangement in this embodiment the current path is defined by two individual superconductor stripes each comprising a metal substrate and a superconductor layer applied onto one side of the metal substrate.

There can be a space between the two individual superconductor stripes of the stripe-shaped superconductor assembly.

A spacer of electrically insulating material can be provided in the space between the two superconductor stripes. The electrically insulating material can be plastics such as Teflon, Polyimide, Aramid etc. or any other electrically insulating material which is stable at low temperature.

According to another embodiment the two individual superconductor stripes can be jointed via their substrates, for example by soldering or gluing etc.

According to yet another embodiment the stripe-shaped superconductor assembly can be composed of a superconductor stripe wherein the substrate is provided with a superconductor layer on both the top and bottom side of the metal substrate.

Preferably, the turns of the coil arrangement of the present invention are electrically insulated by providing an electrically insulating material between the turns. The material can be one as referred to above.

In a preferred embodiment of the present invention the superconductor layer of the superconductor stripe is a rare-earth-oxide based hts material as defined above. In particular, the hts conductor stripe is one known as "coated conductor" using YBCO based hts material.

Generally, there are two main approaches for the production of superconductor stripes such as of coated conductor-type including YBCO coated conductors. According to the first approach metal substrates are used which are untextured (random crystal orientation). In this case a buffer layer must be applied in a suitable crystal orientation for serving as a template for transferring the required crystal orientation to the superconductor layer to be grown.

According to the second approach metal substrates are used which have been treated to be textured, preferably biaxially textured i.e. in axial direction within the plane and perpendicularly to the plane.

In this case the substrate as such can serve as template. Biaxially textured metal substrates can be fabricated by rolling and heat treatment and are known as rolling assisted biaxially textured substrates (RABiTS).

The metal material for the substrate should meet a number of criteria. It should be thermally and chemically stable at elevated temperatures at which the superconductor deposition and formation is carried out. Further, it should be flexible and have good yield strength in order to provide appropriate support for the final conductor. When using the RABiTS route the metal must be one in which a suitable texture can be generated by rolling and heat treatment.

For example, in the production of YBCO coated conductors Ni, Ni alloys, Ag and Ag alloys are suitable for fabricating the biaxially textured substrate via the RABiTS route since these materials allow generation of the required texture for growing the hts layer thereon in the desired crystal alignment. In view of costs Ni and Ni alloys are widely used nowadays.

However, Nickel and Nickel alloys have the drawback to be ferromagnetic with the disadvantageous consequence of significant AC losses in conventional bifilar coil winding as set out above.

According to the present invention the disadvantage in view of AC losses of substrates made of metals, in particular ferromagnetic metals such as Nickel and Nickel alloys, can be overcome.

The present invention is now illustrated in more detail by reference to the accompanying figures, wherein:
- **Figure 1**: shows a bifilar pancake coil of prior art EP 2 041 809 B1;
- **Figure 2**: shows schematically the substrate orientation of prior art bifilar coils such as in prior art pancake coil shown in figure 1, as well as the magnetic field variation between two adjacent turns along the coil;
- **Figure 3**: shows schematically an embodiment of substrate orientation and winding arrangement according to the present invention as well as the magnetic field variation between adjacent turns along the coil; and
- **Figure 4**: shows schematically a further embodiment of substrate orientation and winding arrangement according to the present invention, as well as the magnetic field variation between adjacent turns along the coil.

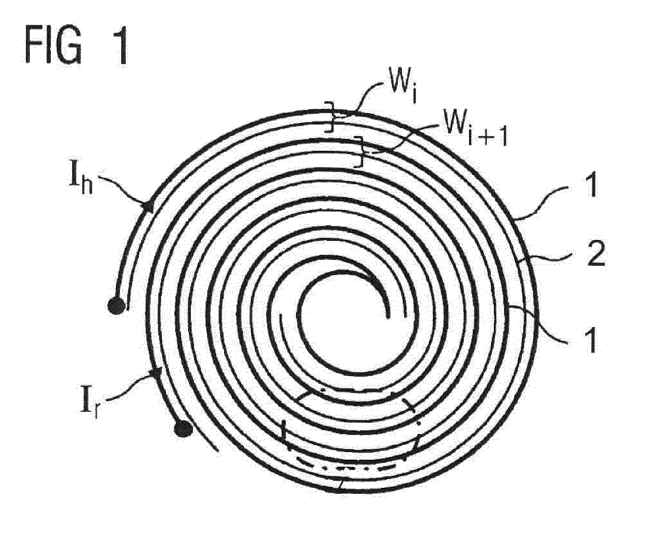

**Figure 1** shows a prior art bifilar pancake coil winding of a hts tape of coated-conductor type 1 with Ih denoting current input, Ir current output, Wi and Wi+1 adjacent turns, as well as spacer 2 running in parallel to the hts tape 1 for separating and insulating adjacent turns.

In this coil arrangement the metal substrate side of the hts tape of coated conductor type faces outwards and the hts layer insides of the arrangement. Consequently, in adjacent turns Wi and Wi+1 the hts layer of turn Wi is directed towards the substrate side of turn Wi+1.

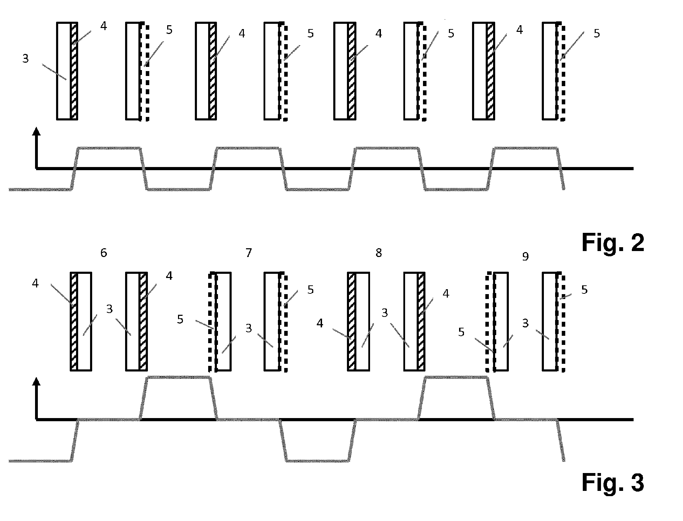

A cross-section of the resulting coil arrangement of figure 1 is shown in figure 2 with reference no. 3 denoting the substrate, 4 the superconductor layer with current flow in first direction and 5 superconductor layer with current flow in opposite direction, the resulting magnetic fields between adjacent turns along the coil arrangement being illustrated in the diagram below.

As follows from the diagram local magnetic fields exist between adjacent turns (with alternating direction corresponding to alternating direction of current flow). Seen along the overall coil winding the sum of the local magnetic fields with alternating direction is about zero, whereas between adjacent turns local magnetic fields with alternating direction exist. Consequently, in such an arrangement the substrate sides are exposed to the magnetic field generated by the current flow. Due to the influence of the magnetic field AC losses are caused in the metal substrate due to hysteretic and eddy current effects. These AC losses are particularly considerable in cases of substrates made of ferromagnetic materials such as nickel and nickel alloys widely used in the production of superconductor stripes such as those of coated-conductor type.

A cross-section through a section of a coil winding of the present invention is shown in **figure 3****.**

In this embodiment the coil arrangement of the present invention is obtained by winding a stripe-shaped superconductor assembly composed of two superconductor stripes in parallel, wherein the substrate sides 3 of the two superconductor stripes are oriented towards each other and the superconductor layers 4, 5 pointing in opposite directions. In this embodiment the current path is defined by the two superconductor stripes with superconductor layer 4 indicating current flow in a first direction and superconductor layer 5 in opposite direction.

Shown are four turns 6, 7, 8 and 9 of the coil arrangement, wherein current flow in the first and third turn 6, 8 is in a first direction, and in the second and fourth turn 7, 9 in opposite direction.

Within each turn 6, 7, 8, 9 the substrate sides 3 are oriented towards each other and between two adjacent turns 6, 7; 7, 8; 8, 9 the respective superconductor layer side 4, 5 faces each other.

The variation of magnetic field along the coil arrangement of figure 3 is shown in the diagram below the cross-section. In the region between the two substrate sides 3 of each turn 6, 7, 8, 9 the magnetic field is zero, whereas in the region between the superconductor layer side 4, 5 of adjacent turns 6, 7; 7, 8; 8, 9 magnetic field exists with opposite direction between consecutive turns 6, 7 and 7, 8 as well as 7, 8 and 8, 9, respectively.

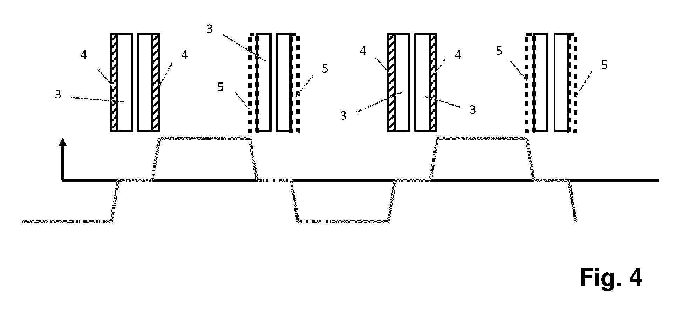

A variation of the embodiment of coil arrangement according to the present invention of figure 3 is shown in **figure 4****.** In this variation the distance between the substrates 3 of the individual turns 6, 7, 8, 9 is closer than in the variation of figure 3. The course of magnetic field of the variation of figure 4 is shown in the diagram of figure 4.

According to a further embodiment it is also possible to join the substrate sides 3 of the two individual superconductor stripes forming the current path of the coil. Such joining can be a accomplished, for example, by soldering or gluing.

According to yet another embodiment it is also possible to use a superconductor stripe wherein a superconductor layer is provided on both the top and bottom faces of the substrate stripe.

In the coil arrangement of the present invention with opposite current flow direction in adjacent turns the substrate side of the superconductor stripe(s) wound into the coil arrangement is located in a region without magnetic field. In the result AC losses due to hysteresis effects and eddy currents caused by the influence of the changing magnetic field onto the metal material of the substrate, are prevented.

Such AC losses are particularly relevant in case of ferromagnetic metal material. The benefits of the present invention are particularly evident when YBCO coated conductors are used for forming the coil arrangement with RABiT substrates made of Nickel or Nickel alloys. Nickel and Nickel alloys are widely used in view of their good texturing capability and low costs, but are ferromagnetic.

As is evident, with current flow in opposite direction in adjacent turns, such as in bifilar winding, the present invention is advantageously applicable for any coil fabrication using superconductor stripes with metal substrates without being restricted to conventional bifilar coil winding.

### List of reference numbers

- 1: superconductor stripe
- 2: spacer
- 3: substrate
- 4: superconductor layer, first current direction
- 5: superconductor layer, opposite current direction
- 6, 7, 8, 9: turn (current path)
- 6, 7; 7, 8; 8, 9: adjacent turns

## Claims

1. Coil arrangement of at least one stripe-shaped superconductor assembly with metal substrate (3) and superconductor layer (4, 5) formed onto at least one side of the metal substrate (3) wherein the at least one stripe-shaped superconductor assembly is formed into a coil arrangement wherein in adjacent turns (6, 7, 8, 9) current flow is in opposite direction in operation, and **characterized in that** in the stripe-shaped superconductor assembly, the metal substrate (3) is sandwiched between two superconductor layers (4, 5) of same current direction.

2. Coil arrangement according to claim 1, wherein the coil arrangement comprises two or more stripe-shaped superconductor assemblies which are wound side by side into the coil arrangement.

3. Coil arrangement according to claim 1 or 2, wherein the stripe-shaped superconductor assembly is composed of two superconductor stripes, each superconductor stripe comprising a metal substrate (3) and provided onto one side of the metal substrate (3) a superconductor layer (4, 5) wherein the superconductor stripes are arranged in parallel with the substrate sides (3) facing each other and the superconductor layer sides (4, 5) pointing outwards.

4. Coil arrangement according to claim 3, wherein the superconductor stripes of the stripe-shaped superconductor assembly are jointed at their substrate sides.

5. Coil arrangement according to claim 1 or 2, wherein the stripe-shaped superconductor assembly comprises a metal substrate (3) and a superconductor layer (4, 5) onto both the top and bottom side of the substrate (3).

6. Coil arrangement according to any of the preceding claims wherein the metal material of the substrate (3) is a ferromagnetic metal.

7. Coil arrangement according to any of the preceding claims wherein the superconductor material is a high temperature superconductor material.

8. Coil arrangement according to claim 7, wherein the high temperature superconductor material has the general formula REBa₂ Cu₃O_{7-δ} wherein RE is at least one selected from the group consisting of rare earth elements and Yttrium, and δ is a number of greater than 0 and less than 1.

9. Coil arrangement according to claim 8, wherein the superconductor material is of YBCO type.

10. Coil arrangement according to any of the preceding claims, wherein the superconductor stripe is a coated conductor comprising a stripe-shaped metal substrate (3) and a high temperature superconductor layer (4, 5) provided onto at least one side of the stripe-shaped metal substrate (3) and, optionally, at least one buffer layer between the metal substrate (3) and the high temperature superconductor layer (4, 5) and/or onto the at least one high-temperature superconductor layer (4, 5).

11. Coil arrangement according to any of the preceding claims wherein the metal substrate (3) is biaxially textured.

12. Coil arrangement according to any of the preceding claims, wherein the coil has a helical or spiral shape.

13. Coil arrangement according to any of the preceding claims, wherein there is at least one layer made of non-ferromagnetic metal on top of each superconductor layer (4, 5).

14. Coil arrangement according to any of the preceding claims, wherein the at least one stripe-shaped superconductor assembly is formed into a bifilar winding.

15. Use of a coil arrangement according to any of the preceding claims in the production of superconducting fault current limiters.

## Patentansprüche

1. Spulenanordnung von zumindest einer streifenförmigen Supraleiterbaugruppe mit einem Metallsubstrat (3) und einer Supraleiterschicht (4,5), die auf zumindest einer Seite des Metallsubstrats (3) gebildet ist, wobei die zumindest eine streifenförmige Supraleiterbaugruppe in eine Spulenanordnung gebildet ist, wobei ein Stromfluss in benachbarten Wicklungen (6, 7, 8, 9) im Betrieb in entgegengesetzte Richtung verläuft, und **dadurch gekennzeichnet, dass** das Metallsubstrat (3) in der streifenförmigen Supraleiterbaugruppe sandwichartig zwischen zwei Supraleiterschichten (4, 5) der gleichen Stromrichtung angeordnet ist.

2. Spulenanordnung nach Anspruch 1, wobei die Spulenanordnung zwei oder mehr streifenförmige Supraleiterbaugruppen umfasst, die nebeneinander in die Spulenanordnung gewickelt sind.

3. Spulenanordnung nach Anspruch 1 oder 2, wobei die streifenförmige Supraleiterbaugruppe aus zwei Supraleiterstreifen zusammengesetzt ist, wobei jeder Supraleiterstreifen ein Metallsubstrat (3) umfasst und auf einer Seite des Metallsubstrats (3) eine Supraleiterschicht (4, 5) vorgesehen ist, wobei die Supraleiterstreifen parallel angeordnet sind, wobei die Substratseiten (3) einander zugewandt sind und die Supraleiterschichtseiten (4, 4) nach außen zeigen.

4. Spulenanordnung nach Anspruch 3, wobei die Supraleiterstreifen der streifenförmigen Supraleiterbaugruppe an ihren Substratseiten verbunden sind.

5. Spulenanordnung nach Anspruch 1 oder 2, wobei die streifenförmige Supraleiterbaugruppe ein Metallsubstrat (3) und eine Supraleiterschicht (4, 5) auf der Ober- und der Unterseite des Substrats (3) umfasst.

6. Spulenanordnung nach einem der vorstehenden Ansprüche, wobei das Metallmaterial des Substrats (3) ein ferromagnetisches Metall ist.

7. Spulenanordnung nach einem der vorstehenden Ansprüche, wobei das Supraleitermaterial ein Supraleitermaterial für hohe Temperaturen ist.

8. Spulenanordnung nach Anspruch 7, wobei das Supraleitermaterial für hohe Temperaturen die allgemeine Formel REBa₂ Cu₃O_{7-δ} aufweist, wobei RE zumindest eines ist, das aus der Gruppe ausgewählt ist, bestehend aus Seltene-Erde-Elementen und Yttrium, und δ eine Zahl größer als 0 und kleiner als 1 ist.

9. Spulenanordnung nach Anspruch 8, wobei das Supraleitermaterial von YBCO-Typ ist.

10. Spulenanordnung nach einem der vorstehenden Ansprüche, wobei der Supraleiterstreifen ein beschichteter Leiter ist, umfassend ein streifenförmiges Metallsubstrat (3) und eine Supraleiterschicht (4, 5) für hohe Temperaturen, die auf zumindest einer Seite des streifenförmigen Metallsubstrats (3) vorgesehen ist, und optional zumindest eine Pufferschicht zwischen dem Metallsubstrat (3) und der Supraleiterschicht (4, 5) für hohe Temperaturen und/oder auf der zumindest einen Supraleiterschicht (4, 5) für hohe Temperaturen.

11. Spulenanordnung nach einem der vorstehenden Ansprüche, wobei das Metallsubstrat (3) biaxial texturiert ist.

12. Spulenanordnung nach einem der vorstehenden Ansprüche, wobei die Spule eine Helix- oder Spiralform aufweist.

13. Spulenanordnung nach einem der vorstehenden Ansprüche, wobei zumindest eine Schicht aus nicht-ferromagnetischem Metall auf jeder Supraleiterschicht (4, 5) vorhanden ist.

14. Spulenanordnung nach einem der vorstehenden Ansprüche, wobei die zumindest eine streifenförmige Supraleiterbaugruppe in eine Bifilarwicklung gebildet ist.

15. Verwendung einer Spulenanordnung nach einem der vorstehenden Ansprüche bei der Herstellung von supraleitenden Fehlerstrombegrenzern.

## Revendications

1. Agencement de bobine d'au moins un ensemble supraconducteur en forme de bande avec un substrat métallique (3) et une couche supraconductrice (4, 5) formée sur au moins un côté du substrat métallique (3), dans lequel le au moins un ensemble supraconducteur en forme de bande est formé dans un agencement de bobine dans lequel, dans les spires (6, 7, 8, 9) adjacentes, la circulation de courant se fait dans la direction opposée, en fonctionnement, et **caractérisé en ce que** dans l'ensemble supraconducteur en forme de bande, le substrat métallique (3) est pris en sandwich entre deux couches supraconductrices (4, 5) de la même direction de courant.

2. Agencement de bobine selon la revendication 1, dans lequel l'agencement de bobine comprend deux ensembles supraconducteurs en forme de bande ou plus qui sont enroulés côte à côte dans l'agencement de bobine.

3. Agencement de bobine selon la revendication 1 ou 2, dans lequel l'ensemble supraconducteur en forme de bande est composé de deux bandes supraconductrices, chaque bande supraconductrice comprenant un substrat métallique (3) et prévue sur un côté du substrat métallique (3), on trouve une couche supraconductrice (4, 5), dans lequel les bandes supraconductrices sont agencées en parallèle par rapport aux côtés de substrat (3) se faisant face et les côtés de couche supraconductrice (4, 5) étant orientés vers l'extérieur.

4. Agencement de bobine selon la revendication 3, dans lequel les bandes supraconductrices de l'ensemble supraconducteur en forme de bande sont assemblées au niveau de leurs côtés de substrat.

5. Agencement de bobine selon la revendication 1 ou 2, dans lequel l'ensemble supraconducteur en forme de bande comprend un substrat métallique (3) et une couche supraconductrice (4, 5) à la fois sur les côtés supérieur et inférieur du substrat (3).

6. Agencement de bobine selon l'une quelconque des revendications précédentes, dans lequel le matériau métallique du substrat (3) est un métal ferromagnétique.

7. Agencement de bobine selon l'une quelconque des revendications précédentes, dans lequel le matériau supraconducteur est un matériau supraconducteur à haute température.

8. Agencement de bobine selon la revendication 7, dans lequel le matériau supraconducteur à haute température a la formule générale REBa₂Cu₃O_{7-δ}, dans lequel RE est au moins un élément choisi dans le groupe comprenant les éléments de terre rare et l'yttrium et δ est un nombre supérieur à 0 et inférieur à 1.

9. Agencement de bobine selon la revendication 8, dans lequel le matériau supraconducteur est du type YBCO.

10. Agencement de bobine selon l'une quelconque des revendications précédentes, dans lequel la bande supraconductrice est un conducteur recouvert comprenant un substrat métallique en forme de bande (3) et une couche supraconductrice à haute température (4, 5) prévue sur au moins un côté du substrat métallique en forme de bande (3) et facultativement, au moins une couche tampon située entre le substrat métallique (3) et la couche supraconductrice à haute température (4, 5) et/ou sur la au moins une couche supraconductrice à haute température (4, 5).

11. Agencement de bobine selon l'une quelconque des revendications précédentes, dans lequel le substrat métallique (3) est texturé de manière biaxiale.

12. Agencement de bobine selon l'une quelconque des revendications précédentes, dans lequel la bobine a une forme hélicoïdale ou de spirale.

13. Agencement de bobine selon l'une quelconque des revendications précédentes, dans lequel il y a au moins une couche réalisée avec du métal non ferromagnétique sur le dessus de chaque couche supraconductrice (4, 5).

14. Agencement de bobine selon l'une quelconque des revendications précédentes, dans lequel le au moins un ensemble supraconducteur en forme de bande est formé dans un enroulement bifilaire.

15. Utilisation d'un agencement de bobine selon l'une quelconque des revendications précédentes, dans la production des limiteurs de courant de défaut supraconducteur.
